# FASCICULE DE BREVET EUROPEEN

(11) **EP 0 527 662 B1**
(45) Date de publication et mention de la délivrance du brevet: **14.05.1997**
(21) Numéro de dépôt: 92401912.8
(22) Date de dépôt: 03.07.1992
(51) Int. Cl.: G01R 29/08, H05K 9/00

(54) **Un appareil pour la mesure des caractéristiques vectorielles d'un signal électrique déporté modulé en amplitude**
Gerät zur Messung der vektoriellen Charakteristika eines frequenzverschobenen, amplitudenmodulierten elektrischen Signals
Apparatus for measuring vector characteristics of a frequency-shifted, amplitude modulated electric signal

(30) Priorité: 08.07.1991 FR 9108533
(43) Date de publication de la demande: 17.02.1993
(73) Titulaire: FRANCE TELECOM, 92131 ISSY LES MOULINEAUX (FR); TELEDIFFUSION DE FRANCE S.A., 92542 Montrouge Cédex (FR)
(72) Inventeur: Piolé, Philippe, F-35700 Rennes (FR)
(74) Mandataire: Keib, Gérard

(56) Documents cités:
- EP-A- 0 248 737
- EP-A- 0 354 135
- CH-A- 676 393
- US-A- 4 887 313
- US-A- 4 962 358
- AP-S INTERNATIONAL SYMPOSIUM, 26 - 30 JUIN 1989, SYMPOSIUM DIGEST, VOLUME I, IEEE, NEW YORK, US, PAGES 86-89; G. BRAUN ET AL.: ANTENNA RADIATION PATTERNS WITH A COMPUTER CONTROLLED 108-220 GHZ TRANSMITTER RECEIVER SYSTEM

## Description

L'invention concerne l'utilisation d'un appareil pour la mesure des caractéristiques vectorielles d'un signal variable déporté, selon les préambules des revendications 1 et 2.

Dans la demande de brevet européen EP-A-0 248 737, qui décrit les caractéristiques des préambules des revendications 1 et 2, il est divulgué un dispositif d'analyse d'un signal électrique modulé en amplitude, comprenant un transposeur de fréquence. La fonction principale de ce dispositif connu est de récupérer l'information vectorielle dans la bande latérale inférieure d'un signal haute fréquence marqué par une modulation basse fréquence, typiquement de l'ordre de 488 Hz, pour faire une analyse de spectre sur le signal marqué. Essentiellement, ce dispositif d'analyse de spectre pour analyser un signal électrique constitué par une porteuse de fréquence Fo modulée en amplitude par un signal de fréquence Fm comprend une entrée générale recevant le signal modulé en amplitude, un oscillateur à quartz délivrant un signal à une fréquence Fq, un circuit transposeur de fréquence possédant une première entrée reliée à l'entrée générale et une seconde entrée reliée à l'oscillateur, le circuit transposeur délivrant sur une sortie un signal correspondant à une porteuse à la fréquence Fq avec deux bandes latérales aux fréquences Fq-Fm et Fq+Fm, un filtre à quartz très étroit du type passe-bande, centré sur la fréquence de l'une des bandes latérales Fq-Fm ou Fq+fm, et coupant la porteuse à la fréquence Fq et l'autre bande latérale, ce filtre ayant une entrée reliée à la sortie du transposeur et une sortie délivrant la bande latérale filtrée, un amplificateur ayant une entrée reliée au filtre passe-bande et une sortie, un détecteur de produit ayant une première entrée reliée à l'oscillateur et recevant un signal à la fréquence Fq, une deuxième entrée reliée à la sortie de l'amplificateur et recevant un signal à la fréquence Fq+Fm ou Fq-Fm, ce détecteur ayant une sortie délivrant un signal à la fréquence Fm, un filtre passe-bande étroit centré sur la fréquence Fm, ayant une entrée reliée à la sortie du détecteur et une sortie, une première voie de traitement reliée à la sortie du filtre passe-bande étroit et apte à délivrer un signal fonction de l'amplitude du signal délivré par le filtre, une seconde voie de traitement reliée à la sortie du filtre passe-bande étroit et apte à délivrer un signal fonction de la phase du signal délivré par le filtre, cette seconde voie ayant une entrée auxiliaire pour l'introduction d'une partie du signal ayant servi à la modulation d'amplitude de la porteuse.

Il est à noter que la bande latérale inférieure du signal marqué à analyser contient les informations d'amplitude et de phase comme la porteuse et la bande latérale supérieure de celui-ci. Par conséquent, le marquage d'un signal par une modulation basse fréquence doit être compris comme étant une façon de faire hériter aux deux bandes latérales créées de l'information contenue dans le signal porteur.

L'invention vise l'utilisation d'un dispositif d'analyse de spectre tel que décrit dans le document précité pour la mesure des caractéristiques vectorielles d'un signal avec déport en ambiance radio-électrique polluée. Un telle mesure s'applique, par exemple, à la qualification d'enceintes blindées radio-électriquement (cages de Faraday).

Jusqu'à présent, en ce qui concerne la qualification d'enceintes blindées, il est classique de placer une antenne d'émission (un générateur de signaux à la fréquence porteuse Fo) et un analyseur de spectre standard ou récepteur calé sur la fréquence porteuse Fo, à l'extérieur de l'enceinte (voir par example US-A-4 962 358). A l'intérieur de l'enceinte, on place une antenne de réception reliée à l'analyseur de spectre par une liaison coaxiale. La traversée du blindage s'effectue par une connectique appropriée. Cette disposition est fréquente lorsqu'il n'est pas possible de placer l'observateur et l'analyseur de spectre à l'intérieur de l'enceinte blindée. Selon cette technique connue, on est confronté à la limitation de la précision de la mesure du fait que la qualité de la liaison coaxiale comme de la connectique de traversée du blindage limite la précision de la mesure d'isolation de l'enceinte à un niveau d'environ 80 dB. En effet le signal à mesurer, transporté par la liaison coaxiale à l'extérieur de l'enceinte est parasité par des signaux issus principalement de l'émetteur et induits dans le câble. Cette perturbation du signal à mesurer est d'autant plus gênante que le signal à mesurer a un niveau faible. On peut envisager de réduire les effets des parasites sur le signal à mesurer par la mise en place d'écrans protecteurs, de gaines tri-axiales, de pièges radio-fréquences. Toutefois ces précautions augmentent considérablement le coût de la mesure et s'adaptent mal à des mesures en hautes fréquences.

L'objet de l'invention est de pallier ces inconvénients de l'état de la technique. En particulier, un objectif de l'invention est est l'utilisation d'un appareil pour mesurer des niveaux d'isolation d'enceintes blindées supérieurs à 100 dB, typiquement jusqu'à 160 dB. L'invention permet en particulier de tirer profit des caractéristiques d'un analyseur de spectre qui est sensible vectoriellement seulement à la bande latérale inférieure de fréquences d'un signal électrique modulé en amplitude.

Un autre objectif de l'invention est d'effectuer des mesures de spectre sur des signaux très faibles dans une bande de fréquences relativement large, de pouvoir disposer l'appareillage de mesure à l'intérieur de l'enceinte blindée. Un objectif de l'invention concerne enfin l'utisation d'un tel appareil de mesure dans des conditions de simplicité, de fiabilité et d'indépendance par rapport à l'environnement parasité de la mesure.

L'invention concerne ainsi l'utilisation d'un appareil pour la mesure des caractéristiques vectorielles d'un signal variable déporté dans lequel le signal variable déporté est marqué par une modulation d'amplitude d'un signal de marquage à basse fréquence pour obtenir, après héritage, un signal à analyser ayant un spectre comportant une fréquence porteuse et deux bandes latérales, le signal de marquage étant amené par une liaison non galvanique insensible aux perturbations radio-électriques. La mesure est effectuée par un analyseur de spectre conforme à celui décrit dans le document précité. L'héritage permet par conséquent d'éliminer les perturbations associées à la fréquence porteuse du signal à analyser en dissociant l'information de sa source génératrice ainsi que des perturbations associées pour réaliser des mesures vectorielles à très bas niveaux.

L'invention a donc pour objet l'utilisation d'un appareil pour la mesure des caractéristiques vectorielles d'un signal variable déporté avec les caractéristiques des revendications 1 et 2.

Avantageusement:
- la fréquence porteuse du signal variable de marquage est une basse fréquence, typiquement 488 Hz.

D'autres caractéristiques et avantages de l'invention apparaîtront encore mieux à la lecture de la description qui suit.
- Les figures 1 et 2 sont des représentations schématiques de l'appareil comportant un circuit de marquage selon l'invention pour mesurer l'isolation de cages blindées radio-électriquement.
- Les figures 3 et 4 sont des représentations schématiques du circuit de marquage selon l'invention.

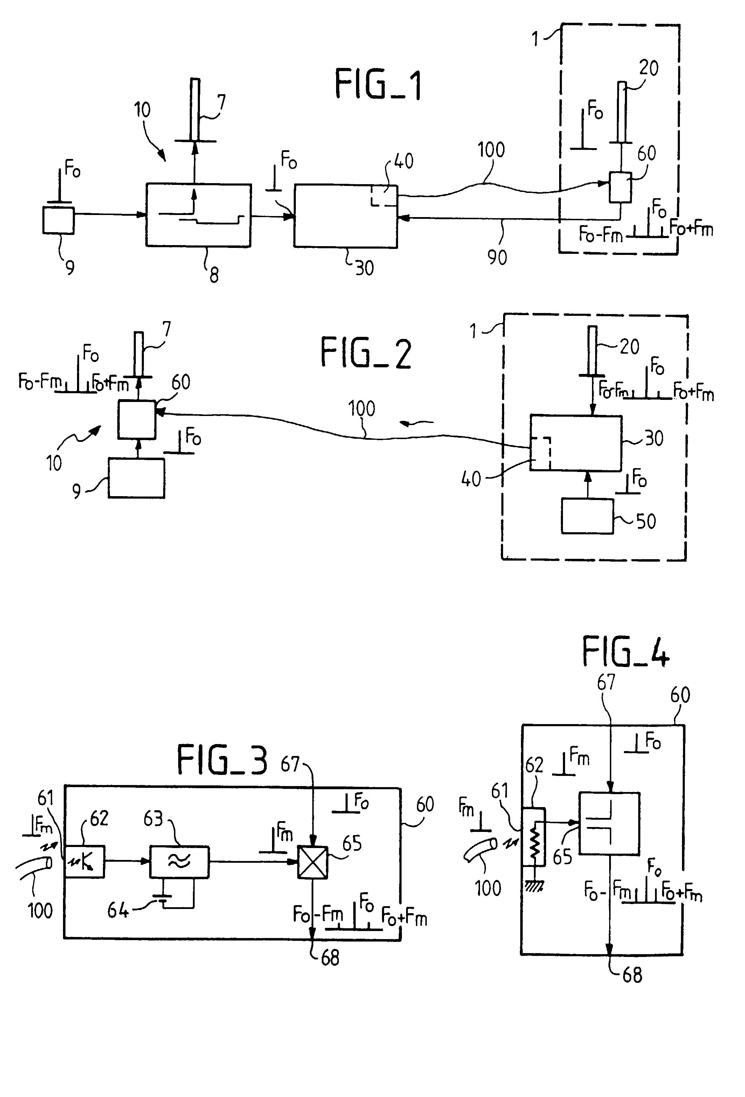

Sur les figures, les mêmes références numériques désignent des éléments identiques. En se reportant aux figures 1 et 2, l'appareil pour mesurer les caractéristiques vectorielles d'un signal variable déporté est utilisé, pour mesurer l'isolation d'une enceinte blindée radio-électriquement telle que 1. La mesure de l'isolation d'enceinte consiste à irradier l'extérieur de l'enceinte par un signal haute fréquence engendré par un émetteur, à capter les rayonnements haute fréquence traversant l'épaisseur de l'enceinte par un récepteur placé à l'intérieur de celle-ci et à mesurer les caractéristiques d'amplitude (éventuellement de phase) du signal capturé par le récepteur avec un analyseur de spectre relié à l'émetteur et au récepteur par des liaisons filaires, par exemple une liaison coaxiale. Dans l'exemple décrit, ci-après l'enceinte blindée 1 présente une isolation au champ électrique de l'ordre de 120 dB à la fréquence de 100 MHz. La puissance d'émission est d'environ 1 Watt.

Plus précisément, l'appareil de mesure, selon l'invention comprend un émetteur 10 engendrant un signal électrique haute fréquence (100MHz) ayant une fréquence porteuse Fo, un récepteur 20 placé dans l'enceinte 1 sensible à une fraction du signal électrique émis, un circuit de marquage 60 recevant en entrée le signal électrique capté par le récepteur 20 ou le signal électrique engendré par l'émetteur 10 et un signal électrique de marquage basse fréquence pour fournir un signal électrique modulé en amplitude à mesurer, un dispositif d'analyse de spectre 30 et un générateur 40 engendrant le signal de marquage. Le générateur 40 est relié au circuit de marquage 60 par une liaison non galvanique 100 comme décrit ci-après.

Le générateur 40 (incorporé ou non à l'analyseur de spectre 30) engendre un signal électrique de marquage basse fréquence, typiquement égale à 488 Hz. Le générateur du signal électrique de marquage peut consister, par exemple, en un oscillateur travaillant à la fréquence Fm.

La liaison non galvanique 100, par exemple une fibre optique 100, entre le circuit de marquage 60 et l'analyseur de spectre 30 traverse la paroi de l'enceinte 1.

Le fait que la modulation externe en sortie du dispositif est acheminée par voie optique vers le modulateur déporté, élimine tout couplage direct sur la fréquence d'émission dont la puissance peut être élevée. La liaison non galvanique 100 entre le générateur et le modulateur évite les couplages directs (externes ou intérieurs) dont les signaux HF de fuite sur la voie mélangeur côté FB (modulation de marquage), et seul le signal reçu par le capteur (antenne de réception) est marqué par la modulation.

On remarquera que l'antériorité EP-248 737 n'envisage pas de déporter la modulation.

Dans le cas de la figure 1, l'émetteur 10 est constitué d'une antenne 7 alimentée à travers un circulateur 8 par un générateur 9 (oscillateur) travaillant à la fréquence Fo. Le circuit de marquage 60 est connecté à la sortie du récepteur 20 (une antenne) pour recevoir d'une part le signal électrique de marquage à la fréquence Fm et d'autre part le signal électrique incident (capté par le récepteur 20) à la fréquence Fo. Le circuit de marquage 60 est placé à l'intérieur de l'enceinte 1. Il restitue en sortie un signal électrique à mesurer ayant un spectre formé d'une fréquence porteuse Fo et de deux bandes latérales Fo-Fm et Fo+Fm. L'analyseur de spectre 30 (placé à l'extérieur de l'enceinte 1) est relié au circuit de marquage 60 par une liaison coaxiale blindée 90 traversant la paroi de l'enceinte 1 pour récupérer l'information portée par la bande latérale Fo-Fm du signal électrique à mesurer, c'est-à-dire l'héritage des informations d'amplitude et de phase du signal reçu par le récepteur 20. L'analyseur de spectre est par ailleurs relié en entrée à travers le circulateur 8 au générateur 9 pour recevoir le signal à la fréquence Fo. A partir des informations d'amplitude et de phase mesurées, on en déduit le niveau d'isolation de l'enceinte 1. Par conséquent, le signal à mesurer qui est transporté par la liaison coaxiale 90 comporte la même information sur trois raies de son spectre. La raie centrale (fréquence Fo) est toujours entachée d'erreurs dues au couplage par la liaison coaxiale. Toutefois, le couplage par liaison coaxiale n'a aucune incidence sur l'information portée par la bande latérale inférieure du signal à analyser. L'analyseur de spectre 30 est donc adapté pour ne prendre en compte que la bande latérale inférieure du signal électrique modulé en amplitude à analyser. Par conséquent, la précision de la mesure n'est pas affectée par la mauvaise qualité de la liaison coaxiale. Ainsi pour une liaison coaxiale du type "RG214", on peut mesurer un niveau d'isolation d'enceinte de l'ordre de 160 dB avec l'appareil selon l'invention.

Dans le cas de la figure 2, l'émetteur 10 est constitué de l'antenne 7 alimenté par un générateur (oscillateur) travaillant à la fréquence Fo. Le circuit de marquage est connecté entre l'antenne 7 et le générateur 9. Le récepteur 20 (une antenne), l'analyseur de spectre 30, le générateur 40 de signal électrique de marquage et un second générateur 50 engendrant un signal de référence ayant une fréquence porteuse Fo sont placés à l'intérieur de l'enceinte 1. Le générateur 40 de signal électrique de marquage est relié par une fibre optique au circuit de marquage 60. Le circuit de marquage 60 recevant le signal électrique de marquage ayant une fréquence porteuse Fm et le signal électrique ayant une fréquence porteuse Fo fournit à l'antenne 7 un signal électrique résultant d'émission dont le spectre est formé d'une raie centrale (Fo) et deux bandes latérales (Fo-Fm,Fo+fm). Ce signal électrique résultant irradie l'enceinte 1. Le récepteur 20, placé dans l'enceinte 1 capture le rayonnement électromagnétique ayant traversé les parois de l'enceinte pour fournir à l'analyseur de spectre 30 un signal à mesurer ayant une raie centrale et deux bandes latérales (correspond au spectre du signal électrique résultant, mais dont les raies sont atténuées par l'isolation de l'enceinte). L'analyseur de spectre 30 ne recueille que l'information utile sur la bande latérale inférieure du signal électrique reçu à l'intérieur de l'enceinte pour mesurer le niveau d'amplitude de ce signal. A partir du niveau d'amplitude mesuré, on en déduit l'amplitude d'isolation de l'enceinte. On remarquera qu'il n'est pas nécessaire de synchroniser les générateurs 9 et 50 puisque l'information de phase n'est pas utile dans l'application décrite.

Sur la figure 3, le circuit de marquage 60 comprend un élément photorécepteur 62 en relation de fonctionnement avec la fibre optique 100 couplée à son entrée 61 et un modulateur 65. L'élément photorécepteur, un phototransistor par exemple, convertit le signal lumineux guidé par la fibre optique 100 en un signal électrique carré de marquage qui est filtré par un filtre passe-bande 63 centré sur la fréquence Fm. Le filtre 63 est alimenté par une batterie 64. Le signal sinusoïdal ayant une fréquence Fin délivré par le filtre 63 alimente une entrée du modulateur d'amplitude 65, l'autre entrée 67 recevant le signal électrique à la fréquence Fo. Le modulateur 65 module l'amplitude du signal à la fréquence Fo par le signal à la fréquence Fm pour restituer sur une sortie 68 un signal électrique résultant ayant un spectre comportant une raie centrale (Fo) et deux bandes latérales (Fo-Fm, Fo+Fm). Sur la figure 4, l'élément photorécepteur est une photorésistance et le modulateur 65 (un modulateur passif) est un circuit hybride (T magique). L'impédance de la photorésistance 62 est modulée par le rayonnement lumineux (à la fréquence Fm) guidé par la fibre optique 100. La modulation de la photorésistance modifie l'adaptation du port de sortie du circuit hybride 65 et par suite son isolation ce qui se traduit par une modulation le signal électrique à la fréquence Fo. Le modulateur 65 module l'amplitude du signal à la fréquence Fo par le signal à la fréquence Fm pour restituer sur une sortie 68 un signal électrique résultant ayant un spectre comportant une raie centrale (Fo) et deux bandes latérales (Fo-Fm, Fo+Fm). Sur la figure 5, l'élément photorécepteur est une photorésistance et le modulateur 65 (un modulateur passif) est un circuit hybride (T magique). L'impédance de la photorésistance 62 est modulée par le rayonnement lumineux (à la fréquence Fm) guidé par la fibre optique 100. La modulation de la photorésistance modifie l'adaptation du port de sortie du circuit hybride 65 et par suite son isolation ce qui se traduit par une modulation d'amplitude du signal électrique arrivant sur l'entrée 67 du modulateur 65.

Il est en particulier non seulement possible de traverser des milieux blindés (cages, etc...) mais également de mettre en oeuvre des liaisons de grande longueur. L'invention s'applique plus particulièrement au cas d'adaptation en parallèle à une infrastructure existante de traversée coaxiale, ainsi que pour effectuer des mesures, comme décrit, sur des blindages électro-magnétiques sans rajout de perturbation.

Bien entendu, l'invention n'est pas limitée à l'exemple de réalisation ci-dessus décrit et on pourra prévoir d'autres variantes d'exécution sans pour cela sortir du cadre de l'invention.

## Revendications

1. Utilisation d'un appareil pour la mesure des caractéristiques vectorielles d'un signal variable déporté, comprenant un dispositif d'analyse (30) de spectre du signal variable déporté, appareil qui comprend en outre un premier générateur (40) de signaux pour engendrer un signal variable de marquage ayant une fréquence porteuse Fm, un circuit de marquage (60) recevant, sur une première entrée (67), un signal variable, ayant une fréquence porteuse Fo, produit par un deuxième générateur de signaux (9) et, sur une deuxième entrée (61), le signal variable de marquage modulant en amplitude le signal variable ayant une porteuse Fo en réponse au signal variable de marquage, le circuit de marquage (60) fournissant au dispositif d'analyse de spectre (30), sur sa sortie (68), un signal variable à mesurer dont le spectre est formé d'une porteuse à la fréquence Fo et deux bandes latérales aux fréquences Fo-Fm et Fo+Fm, le premier générateur (40) de signaux pour engendrer un signal variable de marquage étant relié à la deuxième entrée (61) du circuit de marquage (60) par une liaison non galvanique (100), utilisation caractérisée en ce qu'elle est appliquée à la mesure de l'isolation de cages blindées radioélectriquement (1), le dispositif d'analyse de spectre (30) étant connecté entre un émetteur (10) et un récepteur (20) du signal variable ayant une porteuse Fo, pour analyser le spectre du signal variable reçu par le récepteur (20), l'émetteur (10) et le récepteur (20) étant munis d'antennes (7, 20) et étant disposés, respectivement, à l'extérieur et à l'intérieur de la cage blindée radioélectriquement (1), le circuit de marquage (60) recevant sur sa première entrée (67), le signal variable à fréquence Fo reçu par le récepteur (20), et modulant ce signal, le circuit de marquage (60) et le dispositif d'analyse de spectre (30) étant en outre disposés, respectivement, à l'intérieur et à l'extérieur de la cage blindée radio-électriquement (1), l'antenne (7) d'émetteur (10) étant alimentée à travers un circulateur (8) par le deuxième générateur de signaux (9), le dispositif d'analyse de spectre (30) étant connecté entre la sortie du circulateur (8) et la sortie (68) du circuit de marquage (60), la liaison non galvanique (100) et la liaison entre la sortie (68) du circuit de marquage (60) et le dispositif d'analyse de spectre (30) traversant la cage blindée radioélectriquement (1).

2. Utilisation d'un appareil pour la mesure des caractéristiques vectorielles d'un signal variable déporté, comprenant un dispositif d'analyse (30) de spectre du signal variable déporté, appareil qui comprend en outre un premier générateur (40) de signaux pour engendrer un signal variable de marquage ayant une fréquence porteuse Fm, un circuit de marquage (60) recevant, sur une première entrée (67), un signal variable, ayant une fréquence porteuse Fo, produit par un deuxième générateur de signaux (9) et, sur une deuxième entrée (61), le signal variable de marquage modulant en amplitude le signal variable ayant une porteuse Fo en réponse au signal variable de marquage, le circuit de marquage (60) fournissant, sur sa sortie (68), un signal variable à mesurer dont le spectre est formé d'une porteuse à la fréquence Fo et deux bandes latérales aux fréquences Fo-Fm et Fo+Fm, le premier générateur (40) de signaux pour engendrer un signal variable de marquage étant relié à la deuxième entrée (61) du circuit de marquage (60) par une liaison non galvanique (100), utilisation caractérisée en ce qu'elle est appliquée à la mesure de l'isolation de cages blindées radioélectriquement (1), le dispositif d'analyse de spectre (30) étant connecté entre un émetteur (10) et un récepteur (20) du signal variable ayant une porteuse Fo pour analyser le spectre du signal variable reçu par le récepteur (20), l'émetteur (10) et le récepteur (20) étant munis d'antennes (7, 20) et étant disposés, respectivement, à l'extérieur et à l'intérieur de la cage blindée radioélectriquement (1), la sortie (68) du circuit de marquage (60) étant connectée à l'antenne (7) de l'émetteur (10), le dispositif d'analyse de spectre (30) étant connecté entre le récepteur (20), le premier générateur de signaux (40) et un troisième générateur de signaux (50) qui fournit un signal variable de référence ayant la même fréquence porteuse Fo que le signal signal produit par le deuxième générateur de signaux (9), le circuit de marquage (60) et le dispositif d'analyse de spectre (30) étant en outre disposés, respectivement, à l'extérieur et à l'intérieur de la cage blindée radioélectriquement (1), et la liaison non galvanique (100) traversant la cage blindée radioélectriquement (1).

3. Utilisation selon les revendications 1 ou 2, caractérisée en ce que la fréquence porteuse du signal variable de marquage est une basse fréquence, typiquement 488 Hz.

4. Utilisation selon les revendications 1 ou 2, caractérisée en ce que ladite la liaison non galvanique (100) est une fibre optique (100).

5. Utilisation selon la revendication 4, caractérisée en ce que le circuit de marquage (60) comprend un modulateur d'amplitude (65) ayant deux entrées, une première entrée (67) recevant un signal électrique ayant une fréquence porteuse Fo, une seconde entrée (61) recevant le signal électrique de marquage ayant une fréquence Fm, et une sortie (68) pour délivrer un signal électrique dont le spectre comporte une raie centrale à la fréquence Fo et deux bandes latérales Fo-Fm et Fo+Fm, la seconde entrée (61) étant connectée à un élément photorécepteur (62) illuminé par le rayonnement lumineux guidé par la fibre optique (100).

6. Utilisation selon la revendication 5, caractérisée en ce que l'élément photorécepteur (62) est un phototransistor.

7. Utilisation selon la revendication 5, caractérisée en ce que l'élément photorécepteur (62) est une photorésistance.

## Patentansprüche

1. Verwendung einer Vorrichtung zur Messung der vektoriellen Charakteristika eines variablen, frequenzverschobenen Signals, umfassend ein Analysemittel (30) für das Spektrum des variablen, frequenzverschobenen Signals, wobei die Vorrichtung unter anderem einen ersten Signalgenerator (40) zum Erzeugen eines variablen Kennzeichnungssignals mit einer Trägerfrequenz Fm, einen Kennzeichnungsschaltkreis (60), empfangend, an einem ersten Eingang (67), ein variables Signal mit einer Trägerfrequenz Fo, erzeugt von einem zweiten Signalgenerator (9), und, an einem zweiten Eingang (61), das variable Kennzeichnungssignal, das das variable Signal amplitudenmoduliert, aufweisend eine Trägerfrequenz Fo in Antwort auf das variable Kennzeichnungssignal, umfaßt, wobei der Kennzeichnungsschaltkreis (60) an die Spektralanalyseeinrichtung (30), an ihrem Ausgang (68), ein variables, zu messendes Signal liefert, dessen Spektrum von einer Trägerfrequenz Fo und zwei Seitenbändern mit Frequenzen Fo-Fm und Fo+Fm gebildet wird, wobei der erste Signalgenerator (40) zum Erzeugen eines variablen Kennzeichnungssignals mit dem zweiten Eingang (61) des Kennzeichnungsschaltkreises (60) über eine nicht galvanische Verbindung (100) verbunden ist, wobei die Verwendung dadurch gekennzeichnet ist, daß sie zum Messen der Isolation von radioelektrisch geschlossenen Gehäusen (1) verwendbar ist, daß die Spektralanalyseeinrichtung (30) zwischen einem Emitter (10) und einem Empfänger (20) für das variable Signal mit einer Trägerfrequenz Fo, zum Analysieren des Spektrums des variablen Signals, empfangen von dem Empfänger (20), angeschlossen ist, daß der Emitter (10) und der Empfänger (20) mit Antennen (7, 20) versehen sind und außerhalb bzw. innerhalb des radioelektrisch geschlossenen Gehäuses (1) angeordnet sind, daß der Kennzeichnungsschaltkreis (60) an seinem ersten Eingang (67) das von dem Empfänger (20) empfangene, variable Signal mit der Frequenz Fo empfängt und dieses Signal moduliert, daß der Kennzeichnungsschaltkreis (60) und die Spektralanalyseeinrichtung (30) innerhalb bzw. außerhalb des radioelektrisch geschlossenen Gehäuses (1) angeordnet sind, daß die Antenne (7) des Emitters (10) über einen Zirkulator (8) von dem zweiten Signalgenerator (9) versorgt wird, daß die Spektralanalyseeinrichtung (30) zwischen dem Ausgang des Zirkulators (8) und dem Ausgang (68) der Kennzeichnungsschaltung (60) angeschlossen ist, und daß die nicht galvanische Verbindung (100) und die Verbindung zwischen dem Ausgang (68) des Kennzeichnungsschaltkreises (60) und der Spektralanalyseeinrichtung (30) das radioelektrisch geschlossene Gehäuse (1) durchqueren.

2. Verwendung einer Vorrichtung zur Messung der vektoriellen Charakteristika eines variablen, frequenzverschobenen Signals, umfassend ein Analysemittel (30) für das Spektrum des variablen, frequenzverschobenen Signals, wobei die Vorrichtung unter anderem einen ersten Signalgenerator (40) zum Erzeugen eines variablen Kennzeichnungssignals mit einer Trägerfrequenz Fm, einen Kennzeichnungsschaltkreis (60), empfangend, an einem ersten Eingang (67), ein variables Signal mit einer Trägerfrequenz Fo, erzeugt von einem zweiten Signalgenerator (9), und, an einem zweiten Eingang (61), das variable Kennzeichnungssignal, das das variable Signal amplitudenmoduliert, aufweisend eine Trägerfrequenz Fo in Antwort auf das variable Kennzeichnungssignal, umfaßt, wobei der Kennzeichnungsschaltkreis (60) an die Spektralanalyseeinrichtung (30), an ihrem Ausgang (68), ein variables, zu messendes Signal liefert, dessen Spektrum von einer Trägerfrequenz Fo und zwei Seitenbändern mit Frequenzen Fo-Fm und Fo+Fm gebildet wird, wobei der erste Signalgenerator (40) zum Erzeugen eines variablen Kennzeichnungssignals mit dem zweiten Eingang (61) des Kennzeichnungsschaltkreises (60) über eine nicht galvanische Verbindung (100) verbunden ist, wobei die Verwendung dadurch gekennzeichnet ist, daß sie zum Messen der Isolation von radioelektrisch geschlossenen Gehäusen (1) verwendbar ist, daß die Spektralanalyseeinrichtung (30) zwischen einem Emitter (10) und einem Empfänger (20) für das variable Signal mit einer Trägerfrequenz Fo, zum Analysieren des Spektrums des variablen Signals, empfangen von dem Empfänger (20), angeschlossen ist, daß der Emitter (10) und der Emp-fänger (20) mit Antennen (7, 20) versehen sind und außerhalb bzw. innerhalb des radioelektrisch geschlossenen Gehäuses (1) angeordnet sind, daß der Kennzeichnungsschaltkreis (60) an seinem ersten Eingang (67) das von dem Empfänger (20) empfangene, variable Signal mit der Frequenz Fo empfängt und dieses Signal moduliert, daß der Kennzeichnungsschaltkreis (60) und die Spektralanalyseeinrichtung (30) innerhalb bzw. außerhalb des radioelektrisch geschlossenen Gehäuses (1) angeordnet sind, daß der Ausgang (68) des Kennzeichnungsschaltkreises (60) mit der Antenne (7) des Emitters (10) verbunden ist, daß die Spektralanalyseeinrichtung (30) zwischen dem Emp-fänger (20), dem ersten Signalgenerator (40) und einem dritten Signalgenerator (50), der ein variables Referenzsignal liefert, das die gleiche Trägerfrequenz Fo wie das von dem zweiten Signalgenerator (9) erzeugte Signal aufweist, angeschlossen ist, daß der Kennzeichnungsschaltkreis (60) und die Spektralanalyseeinrichtung (30) außerdem außerhalb bzw. innerhalb des radioelektrisch verschlossenen Gehäuses (1) angeordnet sind, und daß die nicht galvanische Verbindung (100) das radioelektrisch verschlossene Gehäuse (1) durchquert.

3. Verwendung nach Anspruch 1 oder 2, dadurch gekennzeichnet, daß die Trägerfrequenz des variablen Kennzeichnungssignals eine tiefe Frequenz ist, typischerweise 488 Hz.

4. Verwendung nach Anspruch 1 oder 2, dadurch gekennzeichnet, daß besagte nicht galvanische Verbindung (100) ein Glasfaser (100) ist.

5. Verwendung nach Anspruch 4, dadurch gekennzeichnet, daß der Kennzeichnungsschaltkreis (60) einen Amplitudenmodulator (65) umfaßt, aufweisend zwei Eingänge, von denen ein erster Eingang (67) ein elektrisches Signal mit einer Trägerfrequenz Fo empfängt und der zweite Eingang (61) das elektrische Kennzeichnungssignal mit einer Frequenz Fm empfängt, sowie einen Ausgang (68) zum Ausgeben eines elektrischen Signals, dessen Spektrum eine zentrale Frequenz Fo und zwei Seitenbänder Fo-Fm und Fo+Fm trägt, daß der zweite Eingang (61) mit einem Photorezeptorelement (62) verbunden ist, das von der Lichtausstrahlung beleuchtet wird, die von der Glasfaser (100) geführt wird.

6. Verwendung nach Anspruch 5, dadurch gekennzeichnet, daß das Photorezeptorelement (62) ein Phototransistor ist.

7. Verwendung nach Anspruch 5, dadurch gekennzeichnet, daß das Photorezeptorelement (62) ein Photowiderstand ist.

## Claims

1. Use of an apparatus for measuring the vectorial characteristics of an offset variable signal, comprising as analysis device (30) for the spectrum of an offset variable signal, this apparatus. also comprising a first signal generator (40) for producing a variable marking signal having a carrier frequency Fm, a marking circuit (60) which receives at a first input (67) a variable signal. having a carrier frequency Fo, produced by a second signal generator (9), and, at a second input (61), the variable marking signal by which the variable signal having a carrier frequency Fo is amplitude-modulated in response to the variable marking signal, the marking circuit (60) providing the spectrum analysis device (30), at its output (68), with a variable signal to be measured, of which the spectrum is formed by a carrier with frequency Fo and two lateral bands at the frequencies Fo-Fm and Fo+Fm, the first signal generator (40) for generating a variable marking signal being connected to the second input (61) of the marking signal (60) by a non-galvanic connection (100), the said use being characterized by the fact that it is applied to the measurement of the insulation of radio-electrically screened cages (1), the spectrum analysis device (30) being connected between an emitter (10) and a receiver (20) of the variable signal having a carrier frequency Fo, to analyse the spectrum of the variable signal received by the receiver (20), the emitter (10) and the receiver (20) being provided with antennas (7,20) and being positioned, respectively, outside and inside the radio-electrically screened cage (1), the marking circuit (60) receiving at its first input (67) the variable signal with a frequency Fo received by the receiver (20) and modulating this signal, the marking circuit (60) and the spectrum analysis device (30) also being positioned, respectively, inside and outside the radio-electrically screened cage (10), the antenna (7) of the emitter (10) being fed via a circulator (8) by the second signal generator (9), the spectrum analysis device (30) being connected between the output of the circulator (8) and the output (68) of the marking circuit (60), the non-galvanic connection (100) and the connection between the output (68) of the marking circuit (60) and the spectrum analysis device (30) traversing the radio-electrically screened cage (1).

2. Use of an apparatus for measuring the vectorial characteristics of an offset variable signal, comprising an analysis device (30) for the spectrum of an offset variable signal, this apparatus also comprising a first signal generator (40) for producing a variable marking signal having a carrier frequency Fm, a marking circuit (60) which receives at a first input (67) a variable signal having a carrier frequency Fo, produced by a second signal generator (9),and, at a second input (61), the variable marking signal by which the variable signal having a carrier frequency Fo is amplitude-modulated in response to the variable marking signal, the marking circuit (60) providing the spectrum analysis device (30), at its output (68), with a variable signal to be measured, of which the spectrum is formed by a carrier at the frequency Fo and two lateral bands at the frequencies Fo-Fm and Fo+Fm, the first signal generator (40) for generating a variable marking signal being connected to the second input (61) of the marking signal (60) by a non-galvanic connection (100), the said use being characterized by the fact that it is applied to the measurement of the insulation of radio-electrically screened cages (1), the spectrum analysis device (30) being connected between an emitter (10) and a receiver (20) of the variable signal having a carrier frequency Fo, to analyse the spectrum of the variable signal received by the receiver (20), the emitter (10) and the receiver (20) being provided with antennas (7,20) and being positioned, respectively, outside and inside the radio-electrically screened cage (1), the output (68) of the marking circuit (60) being connected to the antenna (7) of the emitter (10), the spectrum analysis device (30) being connected between the receiver (20), the first signal generator (40) and a third signal generator (50) which supplies a variable reference signal having the same carrier frequency Fo as the signal produced by the second signal generator (9), the marking circuit (60) and the spectrum analysis device (30) also being positioned, respectively, outside and inside the radio-electrically screened cage (1), and the non-galvanic connection (100) traversing the radio-electrically screened cage (1).

3. Use in accordance with Claim 1 or 2, characterized by the fact that the carrier frequency of the variable marking signal is a low frequency, amounting in a typical case to 488 Hz.

4. Use in accordance with Claim 1 or 2, characterized by the fact that the said non-galvanic connection (100) is an optical fibre (100).

5. Use in accordance with Claim 4, characterized by the fact that the marking signal (60) comprises in addition an amplitude modulator (65) having two inputs, a first input (67) receiving an electrical signal having a carrier frequency Fo, a second input (61) receiving the electrical marking signal having a frequency Fm, and an output (68) serving to supply an electrical signal of which the spectrum comprises a central line at the frequency Fo and two lateral bands Fo-Fm and Fo+Fm, the second input (61) being connected to a photo-receiving element (62) illuminated by the luminous radiation guided by the optical fibre (100).

6. Use in accordance with Claim 5, characterized by the fact that the photo-receiving element (62) is a photo-transistor.

7. Use in accordance with Claim 5, charactrized by the fact that the photo-receiving element (62) is a photo-resistance.
